(19) Europäisches Patentamt
European Patent Office
Office européen des brevets

(11) **EP 4 539 632 A1**

(12) **EUROPEAN PATENT APPLICATION**

(43) Date of publication:
**16.04.2025** Bulletin 2025/16

(21) Application number: **24206188.5**

(22) Date of filing: **11.10.2024**

(51) International Patent Classification (IPC):
**H10D 30/69** (2025.01)    **H10B 51/30** (2023.01)

(52) Cooperative Patent Classification (CPC):
**H10D 30/701; H10D 62/882; H10D 62/883;**
**H10D 64/685; H10D 64/689;** H10B 51/30;
H10D 30/0415; H10D 64/691

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **13.10.2023 KR 20230137144**
**10.10.2024 KR 20240137684**

(71) Applicant: **Samsung Electronics Co., Ltd**
**Suwon-si, Gyeonggi-do 16677 (KR)**

(72) Inventors:
• **LEE, Hyunjae**
**16678 Suwon-si (KR)**
• **NAM, Seunggeol**
**16678 Suwon-si (KR)**
• **KIM, Donghoon**
**16678 Suwon-si (KR)**
• **YOO, Sijung**
**16678 Suwon-si (KR)**
• **CHOE, Dukhyun**
**16678 Suwon-si (KR)**

(74) Representative: **Elkington and Fife LLP**
**Prospect House**
**8 Pembroke Road**
**Sevenoaks, Kent TN13 1XR (GB)**

(54) **SEMICONDUCTOR DEVICE AND ELECTRONIC DEVICE INCLUDING THE SAME**

(57)    Provided is a semiconductor device including a channel layer including a semiconductor material, a ferroelectric layer arranged on the channel layer and including a ferroelectric material, a gate electrode arranged on the ferroelectric layer, a first insertion layer arranged between the ferroelectric layer and the gate electrode and including a first paraelectric material, and a second insertion layer arranged between the channel layer and the ferroelectric layer and including a second paraelectric material having a dielectric constant higher than a dielectric constant of the first paraelectric material.

FIG. 1

EP 4 539 632 A1

**Description**

FIELD OF THE INVENTION

The disclosure relates to a semiconductor device and an electronic device including the same.

BACKGROUND OF THE INVENTION

Ferroelectrics are materials having ferroelectricity in which internal electric dipole moments are aligned to maintain spontaneous polarization even when an electric field is no longer being applied thereto from the outside. For example, even if a certain voltage is applied to ferroelectrics and the voltage is brought back to 0 V, polarization remains semi-permanently in the ferroelectrics. Research continues to apply these ferroelectric characteristics to logic devices or memory devices. For example, in the case of a ferroelectric field-effect transistor using ferroelectrics, the threshold voltage of the field-effect transistor may vary depending on the polarization direction in the ferroelectrics. A logic device or a memory device may be implemented by using the threshold voltage change characteristic of the ferroelectric field-effect transistor.

SUMMARY OF THE INVENTION

Provided are a semiconductor device and an electronic device including the same.

Additional aspects will be set forth in part in the description which follows and, in part, will be apparent from the description, or may be learned by practice of the presented embodiments of the disclosure.

According to an aspect of an embodiment, a semiconductor device includes a channel layer including a semiconductor material, a ferroelectric layer on the channel layer, the ferroelectric layer including a ferroelectric material, a gate electrode on the ferroelectric layer, a first insertion layer between the ferroelectric layer and the gate electrode and including a first paraelectric material, and a second insertion layer arranged between the channel layer and the ferroelectric layer, the second insertion layer including a second paraelectric material having a dielectric constant higher than a dielectric constant of the first paraelectric material.

The second paraelectric material may be a high-k material.

The first paraelectric material may have a band gap energy greater than a band gap energy of the ferroelectric material included in the ferroelectric layer.

The second paraelectric material may include at least one of SiON, GeON, $SiGeO_xN_y$, $Al_2O_3$, $Y_2O_3$, $SrTa_2O_7$, $HfO_2$, $ZrO_2$, $Ta_2O_5$, SrTiO3, $La_2O_3$, $SrHfO_3$, $BaZrO_3$, $BaHfO_3$, $Ta_2Ti_2O_x$, $TiO_2$, or $BaHf_{0.5}Ti_{0.5}O_3$.

The dielectric constant of the first paraelectric material may be less than 4.

The first paraelectric material may include at least or more of silicon oxide, silicon nitride, silicon oxynitride, or boron nitride.

The dielectric constant of the second paraelectric material may be equal to or greater than 8 and equal to or less than 60.

A thickness of the second insertion layer may be less than a thickness of the first insertion layer.

The thickness of the second insertion layer may be equal to or less than 70% of the thickness of the first insertion layer.

A ratio of the dielectric constant of the second paraelectric material to the dielectric constant of the first paraelectric material is greater than or equal to 1.2.

The second paraelectric material may include at least one of $Al_2O_3$, $Ta_2O_5$, or $La_2O_3$.

The semiconductor device may further include an interface layer between the channel layer and the second insertion layer, the interface layer may include an oxide.

The semiconductor device may further include a charge trap layer between the ferroelectric layer and the first insertion layer, the charge trap layer contacting the ferroelectric layer.

A trap level of the charge trap layer may be lower than a conduction band of the charge trap layer by 1 eV or more.

The charge trap layer may include at least one of AlN, GaN, GeN, SiN, CN, InN, YN, ScN, or ZrN.

A dielectric constant of the paraelectric material included in the charge trap layer may be less than the dielectric constant of the second paraelectric material.

According to another aspect of an embodiment, a semiconductor device includes a channel layer including a semiconductor material, a ferroelectric layer on the channel layer and including a ferroelectric material, a gate electrode on the ferroelectric layer, a first insertion layer between the ferroelectric layer and the gate electrode, the first insertion layer including at least one or more layer, and a second insertion layer between the channel layer and the ferroelectric layer, the second insertion layer including at least one or more layer, wherein a ratio of the dielectric constant exhibited by the entire second insertion layer to the dielectric constant exhibited by the entire first insertion layer is equal to or greater than 1.2.

The first insertion layer may have a multilayer structure including a layer of silicon oxided and a layer of silicon nitrided.

According to another aspect of an embodiment, an electronic device includes a semiconductor substrate, and a plurality of memory cells on the semiconductor substrate and stacked in a first direction, wherein each of the plurality of memory cells includes a channel layer including a semiconductor material, a ferroelectric layer on the channel layer and including a ferroelectric material, a gate electrode on the ferroelectric layer, a first insertion layer between the ferroelectric layer and the gate electrode and including a first paraelectric material, and a second insertion layer between the channel layer and the ferroelectric layer and including a second paraelectric material having a dielectric constant higher than a dielectric constant of the first paraelectric material such that a ratio of the dielectric constant of the second paraelectric material to the dielectric constant of the first paraelectric material is equal to or greater than 1.2, wherein the channel layer, the second insertion layer, the ferroelectric layer, the first insertion layer, and the gate electrode are sequentially disposed in a second direction perpendicular to the first direction.

A spacer may be between adjacent gate electrodes of the plurality of memory cells, and may include an insulating material.

According to another aspect of an embodiment, an electronic device includes an array including a plurality of synaptic elements arranged in two dimensions, wherein each of the plurality of synaptic elements includes an access transistor and a ferroelectric field effect transistor, wherein the ferroelectric field effect transistor includes a channel layer including a semiconductor material, a ferroelectric layer arranged on the channel layer and including a ferroelectric material, a gate electrode arranged on the ferroelectric layer, a first insertion layer arranged between the ferroelectric layer and the gate electrode and including a first paraelectric material, and a second insertion layer arranged between the channel layer and the ferroelectric layer and including a second paraelectric material having a dielectric constant higher than a dielectric constant of the first paraelectric material, wherein a ratio of the dielectric constant of the second paraelectric material to the dielectric constant of the first paraelectric material is greater than or equal to 1.2.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a cross-sectional view illustrating a schematic structure of a semiconductor device according to at least one embodiment;

FIG. 2 is a cross-sectional view conceptually showing a charge distribution in a semiconductor device according to at least one embodiment when the semiconductor device is in a program state;

FIG. 3 shows examples of charge density in a semiconductor device according to at least one embodiment when the semiconductor device is in a program state;

FIG. 4 is a cross-sectional view conceptually showing a charge distribution in a semiconductor device according to at least one embodiment when the semiconductor device is in an erase state;

FIG. 5 shows examples of charge density in a semiconductor device according to at least one embodiment when the semiconductor device is in an erase state;

FIG. 6A is a graph showing examples of changes in an electric field in a first insertion layer and a second insertion layer according to a dielectric constant ratio when a semiconductor device according to at least one embodiment is in a program state;

FIG. 6B is a graph showing an example of the amount of charge traps in a first insertion layer and a second insertion layer according to a dielectric constant ratio when a semiconductor device according to at least one embodiment is in a program state;

FIG. 7 is a cross-sectional view illustrating a schematic structure of a semiconductor device according to at least one embodiment;

FIG. 8 is a cross-sectional view illustrating a schematic structure of a semiconductor device according to at least one embodiment;

FIG. 9 is a cross-sectional view illustrating a schematic structure of a memory device according to at least one embodiment;

FIG. 10 is a cross-sectional view illustrating a schematic structure of a memory device according to at least one embodiment;

FIG. 11A is a cross-sectional view of a schematic structure of a memory device according to at least one embodiment, and FIG. 11B is a cross-sectional view taken along line AA' of FIG. 11A;

FIG. 12 is a diagram illustrating an equivalent circuit of a memory device according to at least one embodiment;

FIG. 13 is a schematic circuit diagram of a neural network device according to at least one embodiment; and

FIG. 14 is a block diagram schematically illustrating an electronic device including a neural network device according to at least one embodiment.

DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments will be described in detail with reference to the accompanying drawings. The embodiments described below are merely exemplary and various modifications are possible from these embodiments. In the following drawings, the same or similar reference numerals refer to the same or similar components, and the size of each component in the drawings may be exaggerated for clarity and convenience of description.

When the terms "about" or "substantially" are used in this specification in connection with a numerical value and/or geometric terms, it is intended that the associated numerical value includes a manufacturing tolerance (e.g., $\pm10\%$) around the stated numerical value. Further, regardless of whether numerical values and/or geometric terms are modified as "about" or "substantially," it will be understood that these values should be construed as including a manufacturing or operational tolerance (e.g., $\pm10\%$) around the stated numerical values and/or geometric. When referring to "C to D", this means C inclusive to D inclusive unless otherwise specified.

Hereinafter, it will also be understood that spatially relative terms, such as "above", "top", etc., are intended to encompass different orientations of the device in use or operation in addition to the orientation depicted in the figures, and that the device may be otherwise oriented (rotated 90 degrees or at other orientations) and the spatially relative terms used herein interpreted accordingly; and the term "upper portion" or "on" may also include "to be present above, below, in the left and right sides on a non-contact basis" as well as "to be on the top, bottom, left, and right portions in directly contact with".

Terms such as first, second, and so on may be used to describe various components, but are used only for the purpose of distinguishing one component from another. These terms do not limit the difference in the material or structure of the components.

Singular expressions include plural expressions unless they are explicitly meant differently in context. In addition, when a part "includes" a component, this means that it may further include other components, not excluding other components, unless otherwise indicated and/or opposed.

Further, the terms "unit", "module" or the like mean a unit that processes at least one function or operation, which may be implemented in processing circuitry such as hardware, software, and/or a combination of hardware and software. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc., and/or electronic circuits including said components.

The use of the term "the" and similar indicative terms may correspond to both singular and plural.

The operations constituting the method may be performed in an appropriate order unless there is an explicit mention that the operations should be performed in the order described. In addition, the use of all illustrative terms (e.g., etc.) is simply intended to detail technical ideas and, unless limited by the claims, the scope of rights is not limited due to such illustrative terms.

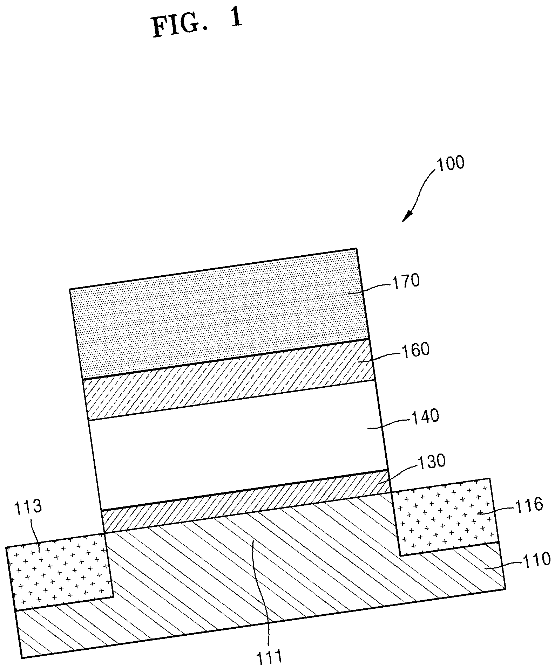

FIG. 1 is a cross-sectional view illustrating a schematic structure of a semiconductor device according to at least one embodiment.

Referring to FIG. 1, a semiconductor device 100 includes a channel layer 111, a ferroelectric layer 140 arranged on the channel layer 111 and including a ferroelectric material, a gate electrode 170 arranged on the ferroelectric layer 140, a first insertion layer 160 arranged between the ferroelectric layer 140 and the gate electrode 170, and including a first paraelectric material, and a second insertion layer 130 arranged between the channel layer 111 and the ferroelectric layer 140 and including a second paraelectric material having a dielectric constant different from the first paraelectric material. In at least one embodiment, the dielectric constant of the second paraelectric material included in the second insertion layer 130 may be greater than the dielectric constant of the first paraelectric material included in the first insertion layer 160.

The first insertion layer 160 may be in contact with the ferroelectric layer 140. For example, the first paraelectric material included in the first insertion layer 160 may be in contact with the ferroelectric layer 140. The first insertion layer 160 may include a plurality of dielectric layers, and in these cases, the dielectric constant of the material directly contacting the ferroelectric layer 140 may be less than the dielectric constant of the second paraelectric material included in the second insertion layer 130.

The semiconductor device 100 is a field effect transistor that exhibits a different threshold voltage according to the voltage applied to the gate electrode 170.

In at least one embodiment, the channel layer 111 includes a semiconductor material. The channel layer 111 may be defined as a region of a substrate 110 between a source region 113 and a drain region 116 spaced apart from each other on the substrate 110 including a semiconductor material. For example, the channel layer 111 may be defined as a semiconductive region between the source region 113 and the drain region 116 in the substrate 110 on which the source region 113 and the drain region 116 are formed.

The source region 113 and the drain region 116 may be doped with a first conductance type, and the substrate 110 may be doped with a second conductance type electrically opposed to the first conductance type. For example, the substrate 110 may include a p-type semiconductor, the source region 113 and the drain region 116 may include an n-type semiconductor, or the substrate 110 may include an n-type semiconductor, and the source region 113 and the drain region 116 may include a p-type semiconductor. The substrate 110 may be doped at a relatively low concentration of about $10^{16}$ to $10^{17}/cm^3$, while the source region 113 and the drain region 116 may be doped at a relatively high concentration of about $10^{19}$ to $10^{21}/cm^3$ for a comparatively low resistance. The source region 113 and the drain region 116 may be formed by doping both sides of the upper portion of the substrate 110, respectively. An upper region of the substrate 110 in which the source region 113 and the drain region 116 are not formed becomes the channel layer 111. However, this is only one example embodiment. For example, the channel layer 111 may alternatively, and/or additionally, including a semiconductor material and/or layer disposed onto the substrate 110.

The channel layer 111 may include a group IV semiconductor, a two-dimensional semiconductor, an oxide semiconductor. The channel layer 111 may include, for example, silicon (Si), germanium (Ge), SiGe, molybdenum disulfide ($MoS_2$), tungsten diselenide ($WSe_2$), graphene, indium gallium zinc oxide (IGZO), indium-tungsten-oxide (IWO), zinc-tin-oxide (ZnSnO and/or ZTO), and/or the like. The channel layer 111 may also include a group III-V compound semiconductor, a group II-VI compound semiconductor, and/or the like.

The substrate 110, the source region 113, and the drain region 116 may also each include the material of the channel layer 111 described above.

When the substrate 110, the channel 111, the source region 113, and the drain region 116 include Si, Ge, SiGe, and/or the like, the substrate 110 and the channel 111 may be doped with at least one dopant of B, Al, Ga, and In, and the source region 113 and the drain region 116 may be doped with at least one dopant of P, As, and Sb. In these cases, the semiconductor device 100 be referred to as an n-channel metal oxide semiconductor field effect transistor (NMOS). Alternatively, the substrate 110 and the channel 111 may be doped with at least one dopant of P, As, and Sb, and the source region 113 and the drain region 116 may be doped with at least one dopant of B, Al, Ga, and In. In these cases, the semiconductor device 100 may be referred to as a p-channel metal oxide semiconductor field effect transistor (PMOS).

In at least one embodiment, the ferroelectric layer 140 includes a ferroelectric material. Ferroelectrics are materials with ferroelectricity that maintain spontaneous polarization by aligning internal electric dipole moments without an electric field being applied from an external electric field source. The threshold voltage of the semiconductor device 100 may change depending on a polarization direction of the ferroelectric layer 140, for example, a direction from the gate electrode 170 to the channel 111, or vice versa.

In at least one embodiment, the ferroelectric material included in the ferroelectric layer 140 may include a hafnium oxide material and/or an aluminum nitride material. For example, the ferroelectric material may have a structure in which a dopant is inserted into a hafnium oxide-based material and/or a structure in which a dopant is inserted into an aluminum nitride-based material. When the ferroelectric material included in the ferroelectric layer 140 is a hafnium oxide-based material, the dopant may be at least one of zirconium (Zr), lanthanum (La), aluminum (Al), silicon (Si), yttrium (Y), and/or gadolinium (Gd). When the ferroelectric material included in the ferroelectric layer 140 is an aluminum nitride-based material, the dopant may be at least one of boron (B) and/or scandium (Sc).

In addition, the ferroelectric layer 140 may include, for example, a ferroelectric having at least one of a fluorite structure, a perovskite structure, and/or a wurtzite structure. The ferroelectric having a fluoride structure may include, for example, hafnium oxide ($HfO_2$). For example, the hafnium oxide may be doped with at least one element of Zr, La, Al, Si, Y and/or Gd. In at least one embodiment, the ferroelectric layer 140 may include an antiferroelectric material. For example, the antiferroelectric material may include zirconium oxide. For example, the zirconium oxide may be doped with at least one element of hafnium (Hf), lanthanum (La), aluminum (Al), silicon (Si), yttrium (Y), and/or gadolinium (Gd). In addition, the ferroelectric having a perovskite structure may include, for example, lead zirconate titanate (PZT). The ferroelectric having a wurtzite structure may include, for example, zinc oxide (ZnO) and/or aluminum nitride (AlN). The ferroelectric of such a wurtzite structure may be doped with, for example, at least one element of boron (B) and scandium (Sc). In addition, the ferroelectric layer 140 may include the antiferroelectric material as well as the ferroelectric material described above. For example, the ferroelectric layer 140 may include $ZrO_2$.

In at least one embodiment, the ferroelectric layer 140 may include at least one of hafnium (Hf) and zirconium (Zr). For example, the ferroelectric layer 140 may include hafnium and zirconium in substantially the same element ratio (e.g., $Hf_{0.5}Zr_{0.5}O_2$), and additionally, at least one dopant, e.g., element among lanthanum (La), aluminum (Al), silicon (Si), yttrium (Y), and gadolinium (Gd) at a ratio of less than about 10 at%.

The thickness of the ferroelectric layer 140 may be, for example, about 5 nm to about 20 nm. However, the embodiments are not limited thereto.

The gate electrode 170 may comprise a conductive material. For example, the gate electrode 170 may have conductance of approximately 1 Mohm/square or less. In at least one embodiment, the gate electrode 170 may include one or more selected from the group consisting of metals, metal nitrides, metal carbides, polysilicon, and/or combinations thereof. For example, the metal may include aluminum (Al), tungsten (W), molybdenum (Mo), titanium (Ti), tantalum (Ta), and/or the like; the metal nitride film may include a titanium nitride (TiN) film, a tantalum nitride (TaN) film, and/or the like; and the metal carbide may be an aluminum and/or silicon-doped (or contained) metal carbide, and may include, for example, TiAlC, TaAlC, TiSiC, TaSiC and/or the like.

In at least one embodiment, the gate electrode 170 may have a structure in which a plurality of materials are stacked. For example, the gate electrode may have a stacked structure of a metal nitride layer/metal layer, such as TiN/Al, and/or a stacked structure of a metal nitride layer/metal carbide layer/metal layer, such as TiN/TiAlC/W. The gate electrode 170 may include a titanium nitride (TiN) layer and/or molybdenum (Mo), and the example may be used in various modifications. In addition, the gate electrode 170 may include a conductive two-dimensional material. For example, the conductive two-dimensional material may include at least one of graphene, black phosphorus, amorphous boron nitride, two-dimensional hexagonal boron nitride (h-BN), phosphorene, and/or the like.

The first insertion layer 160 arranged between the ferroelectric layer 140 and the gate electrode 170, and the second insertion layer 130 arranged between the ferroelectric layer 140 and the channel layer 111 may be provided to increase a memory window of the semiconductor device 100. The memory window is a difference between two different threshold voltages of the semiconductor device 100. As the memory window increases, the operational reliability of the semiconductor device 100 may be improved. For example, the memory window of the semiconductor device 100 may be about 6.5 V or more.

As the amount of charge traps at the interface between the first insertion layer 160 and the ferroelectric layer 140 is relatively large and the amount of charge traps at the interface between the second insertion layer 130 and the ferroelectric layer 140 is relatively small, the memory window of the semiconductor device 100 may increase.

The first paraelectric material included in the first insertion layer 160 may be a low-k material such that more charges are trapped at an interface with the ferroelectric layer 140 and the trapped charges do not escape through the gate electrode 170. For example, the low-k paraelectric material may have a dielectric constant (k) less than or equal to silicon dioxide. The dielectric constant of the first paraelectric material included in the first insertion layer 160 may be less than about 10, about 8 or less, about 7 or less, about 6 or less, and/or about 5 or less. In at least one embodiment, the first paraelectric material may include at least one or more of silicon oxide, silicon nitride, silicon oxynitride, or boron nitride. The first paraelectric material may have a dielectric constant greater than 1 and less than about 4. The first paraelectric material may have a dielectric constant of about 1 to about 3.9. The first paraelectric material may have a dielectric constant greater than about 3 and less than about 8. The first paraelectric material may have a dielectric constant of about 3.5 to about 7.5. The first paraelectric material may have a dielectric constant greater than about 4 and less than about 7. The first paraelectric material may have band gap energy greater than band gap energy of the ferroelectric material included in the ferroelectric layer 140.

The second paraelectric material included in the second insertion layer 130 may be a high-k material and may reduce (and/or minimize) the amount of charge trap at the interface between the second insertion layer 130 and the ferroelectric layer 140. For example, the high-k paraelectric material may have a dielectric constant (k) higher than silicon oxide. In at least one embodiment, the second paraelectric material may include SiON, GeON, $SiGeO_xN_y$, $Al_2O_3$, $Y_2O_3$, $SrTa_2O_7$, $HfO_2$, $ZrO_2$, $Ta_2O_5$, SrTiO3, $La_2O_3$, $SrHfO_3$, $BaZrO_3$, $BaHfO_3$, $Ta_2Ti_2O_x$, $TiO_2$, and/or $BaHf_{0.5}Ti_{0.5}O_3$. The second paraelectric material may include at least one or more of $Al_2O_3$, $Ta_2O_5$, or $La_2O_3$. The dielectric constant of the second paraelectric material may be about equal to or greater than 3.5, equal to or greater than 4, equal to or greater than 4.5, equal to or greater than 6, equal to or greater than 8, equal to or greater than 9, or equal to or greater than 20, and equal to or less than about 60. The dielectric constant of the second paraelectric material may be about 9 to about 10. The dielectric constant of the second paraelectric material may be about 26 to about 28.

A ratio of the dielectric constant of the second paraelectric material included in the second insertion layer 130 to the dielectric constant of the first paraelectric material included in the first insertion layer 160 may be greater than 1, equal to or greater than 1,1, equal to or greater than 1,2, equal to or greater than 1,3, equal to or greater than 1,5, equal to or greater than 1,7, or, equal to or greater than 2.0, and less than or equal to 20, less than or equal to 15, or and less than or equal to 10.

The thickness of the second insertion layer 130 may be less than that of the first insertion layer 160. For example, the thickness of the first insertion layer 160 may be about 3 nm or more, and the thickness of the second insertion layer 130 may be less than about 3 nm. The thickness of the first insertion layer 160 may be greater than or equal to about 2 nm and less than or equal to about 10 nm, and the thickness of the second insertion layer 130 may be less than about 2 nm. The thickness of the second insertion layer 130 may be about 70 % or less, about 50% or less, and/or about 1/3 or less of the thickness of the first insertion layer 160.

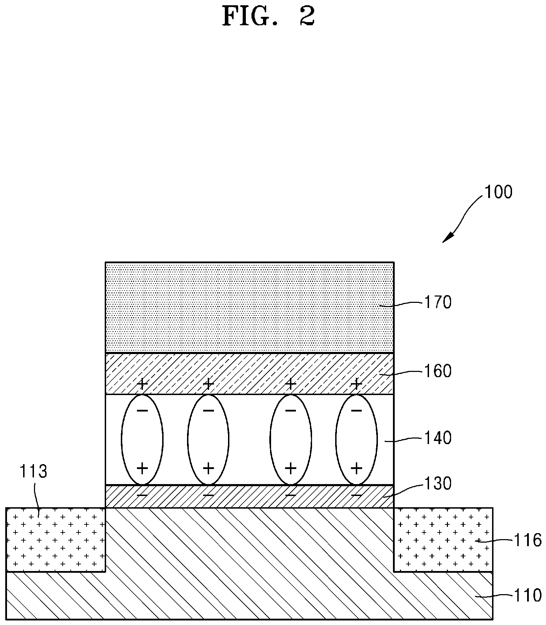

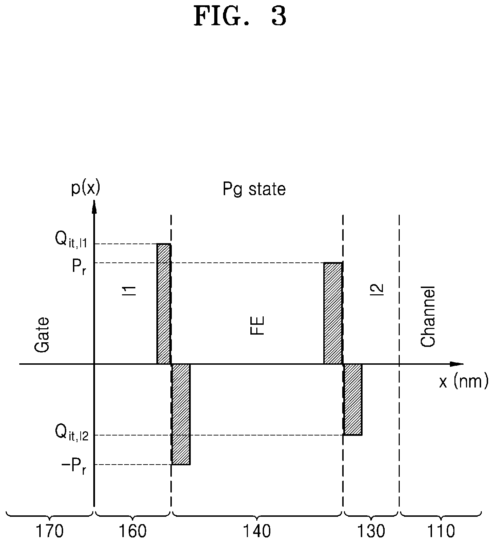

FIG. 2 is a cross-sectional view conceptually showing a charge distribution in a semiconductor device when the semiconductor device according to at least one embodiment is in a program state, and FIG. 3 shows examples of a charge density in a semiconductor device when the semiconductor device according to at least one embodiment is in a program state.

Referring to FIG. 2, in the case of an NMOS type semiconductor device 100, when positive charges in the ferroelectric layer 140 are directed toward the channel 111 and negative charges are directed toward the gate electrode 170, the semiconductor device 100 may be in a program state. In the program state, negative charges may be collected in the second insertion layer 130, and positive charges may be collected in the first insertion layer 160. In particular, negative charges may be collected at an interface with the ferroelectric layer 140 in the second insertion layer 130. In addition, positive charges may be collected at an interface with the ferroelectric layer 140 in the first insertion layer 160. In such a program state, electrons may easily flow along the channel layer 111 and the threshold voltage of the semiconductor device 100 may be lowered.

In the graph of FIG. 3, the vertical axis represents the charge density, and the horizontal axis represents the positions of the gate electrode 170, the first insertion layer 160, the ferroelectric layer 140, the second insertion layer 130, and the channel layer 111 in the semiconductor device 100. Referring to FIG. 3, a charge density $Q_{it,\ I1}$ of positive charges trapped at an interface with the ferroelectric layer 140 in the first insertion layer 160 may be greater than a polarization value $P_r$ of the ferroelectric layer 140. In addition, the absolute value of the charge density $Q_{it,\ I2}$ of negative charges trapped at the interface with the ferroelectric layer 140 in the second insertion layer 130 may be less than the absolute value of the polarization value $-P_r$ of the ferroelectric layer 140.

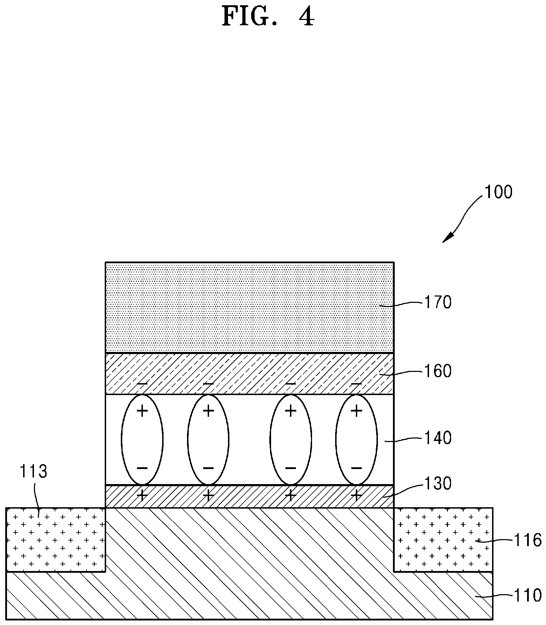

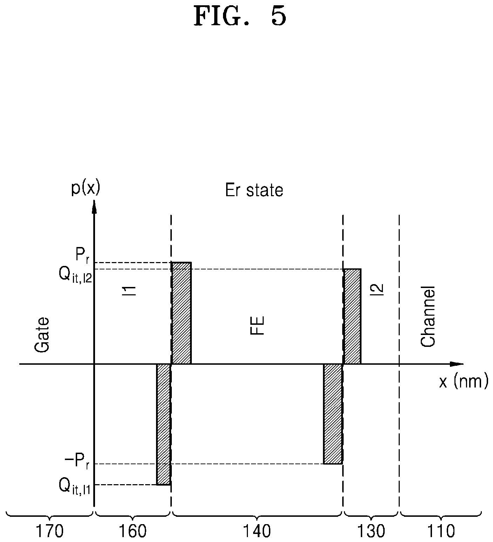

FIG. 4 is a cross-sectional view conceptually showing a charge distribution in a semiconductor device when the semiconductor device according to at least one embodiment is in an erase state, and FIG. 5 shows examples of a charge density in a semiconductor device when the semiconductor device according to at least one embodiment is in an erase state.

Referring to FIG. 4, in the case of an NMOS type semiconductor device 100, when negative charges in the ferroelectric layer 140 are directed toward the channel 111 and positive charges are directed toward the gate electrode 170, the semiconductor device 100 may be in an erase state. The program state and the erase state may be selectively switched by applying a positive coercive voltage or a negative coercive voltage to the gate electrode 170 of the semiconductor device 100. In the erase state, positive charges may be collected in the second insertion layer 130, and negative charges may be collected in the first insertion layer 160. Positive charges may be collected to the interface with the ferroelectric layer 140 in the second insertion layer 130, and negative charges may be collected to the interface with the ferroelectric layer 140 in the first insertion layer 160. In such an erase state, electrons may not easily flow along the channel layer 111 and the threshold voltage of the semiconductor device 100 may be heightened.

Referring to FIG. 5, the absolute value of the charge density of negative charges trapped at an interface with the ferroelectric layer 140 in the first insertion layer 160 may be greater than the absolute value of the polarization value $-P_r$ of the ferroelectric layer 140. In addition, the charge density of positive charges trapped at the interface with the ferroelectric layer 140 within the second insertion layer 130 may be less than the polarization value $P_r$ of the ferroelectric layer 140.

Although the description of FIGS. 2 to 5 illustrates that the semiconductor device 100 is an NMOS, the same principle may be applied to the case where the semiconductor device 100 is a PMOS. For example, when the semiconductor device 100 is a PMOS, it would be understood that the polarities of the charges described in FIGS. 2 to 5 may be reversed.

As shown in FIGS. 3 and 5, the semiconductor device 100 may increase the memory window of the semiconductor device 100 by including a first insertion layer 160 having a large amount of charge traps and a second insertion layer 130 having a small amount of charge traps. In addition, the amount of charge trap in the second insertion layer 130 may be less than the amount of charge trap between the gate electrode 170 and the ferroelectric layer 140 (e.g., the amount of charge trap in the first insertion layer 130) and may be less than the polarization in the ferroelectric layer 140. Accordingly, the memory window of the semiconductor device 100 may be further increased.

The memory window (MW) of the semiconductor device 100 may be expressed by the following Equation 1.

【Equation 1】

$$MW = \frac{(\ \Delta P - \Delta Q_{it,\ I2}\ )}{C_{Ferro}} + \frac{(\ \Delta Q_{it,\ I1} - \Delta Q_{it,I2}\ )}{C_{I1}}$$

In Equation 1 above, $\Delta P$ is the polarization amount of the ferroelectric layer 140, $\Delta Q_{it,I2}$ is the amount of charge trapped at the interface between the ferroelectric layer 140 and the second insertion layer 130, $\Delta Q_{it,I1}$ is the amount of charge trapped at the interface between the ferroelectric layer 140 and the first insertion layer 160, $C_{Ferro}$ is the capacitance of the ferroelectric layer 140, and Cn is the capacitance of the first insertion layer 160.

As described above, since the semiconductor device 100 according to the embodiment has a structure in which $\Delta Q_{it,I2}$ may decrease and $\Delta Q_{it,I1}$-$\Delta Q_{it,I2}$ may increase, the semiconductor device 100 may have a large memory window.

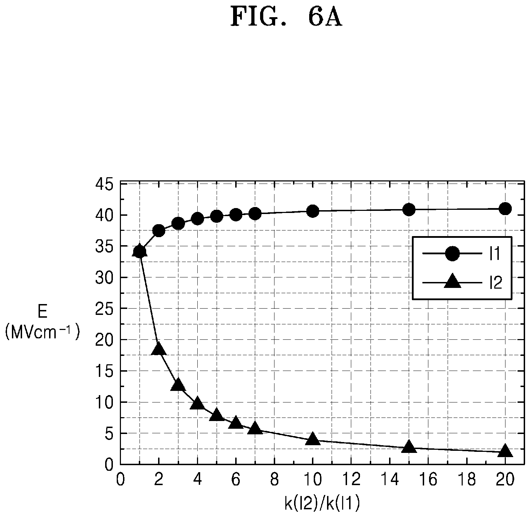

FIG. 6A is a graph showing examples of changes in an electric field in a first insertion layer and a second insertion layer according to a dielectric constant ratio when a semiconductor device according to at least one embodiment is in a program state.

In the graph, k(I2) is the dielectric constant of the second paraelectric material included in the second insertion layer 130, and k(I1) is the dielectric constant of the first paraelectric material included in the first insertion layer 160. As k(I2)/k(I1) increases, the electric field intensity in the first insertion layer 160 increases and the electric field intensity in the second insertion layer 130 decreases.

As k(I2)/k(I1) increases, the electric field intensity in the first insertion layer 160 increases at a very sharp slope and the electric field intensity in the second insertion layer 130 decreases at a very sharp slope. When k(I2)/k(I1) is approximately 10 or more and/or approximately 15 or more, the increase in the electric field intensity in the first insertion layer 160 and the decrease in the electric field intensity in the second insertion layer 130 are gradually saturated.

In consideration of this, the first paraelectric material of the first insertion layer 160 and the second paraelectric material of the second insertion layer 130 may be set so that k(I2)/k(I1) is greater than about 1.. The first paraelectric material of the first insertion layer 160 and the second paraelectric material of the second insertion layer 130 may be determined so that the k(I2)/k(I1) is about 10 or less, about 15 or less, and/or about 20 or less. The first paraelectric material of the first insertion layer 160 and the second paraelectric material of the second insertion layer 130 may be determined so that k(I2)/k(I1) is greater than 1 and equal to or less than about 20, or equal to or greater than about 1.2 and equal to or less than about 15. The first paraelectric material of the first insertion layer 160 and the second paraelectric material of the second insertion layer 130 may be determined so that k(I2)/k(I1) is greater than 1, equal to or greater than 1.1, equal to or greater than 1.2, equal to or greater than 1.3, equal to or greater than 1.5, equal to or greater than 1.7, or, equal to or greater than 2.0, and equal to or less than about 20, equal to or less than about 15, or equal to or less than about 10.

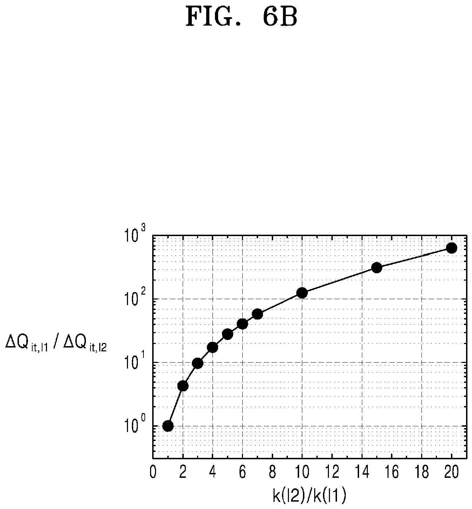

FIG. 6B is a graph showing an example of the amount of charge traps in a first insertion layer and a second insertion layer according to a dielectric constant ratio when a semiconductor device according to at least one embodiment is in a program state.

The graph shows the ratio of the amount of charges $\Delta Q_{it,I1}$ trapped at the interface between the ferroelectric layer 140 and the first insertion layer 160 to the amount of charges $\Delta Q_{it,I2}$ trapped at the interface between the ferroelectric layer 140 and the second insertion layer 130 according to the dielectric constant ratio. It may be seen that as k(I2)/k(I1) increases, $\Delta Q_{it,I1}/\Delta Q_{it,I2}$ increases rapidly. Considering this graph and that $\Delta Q_{it,I1}/\Delta Q_{it,I2}$ contributes to memory windows, k(I2)/k(I1) may be appropriately set.

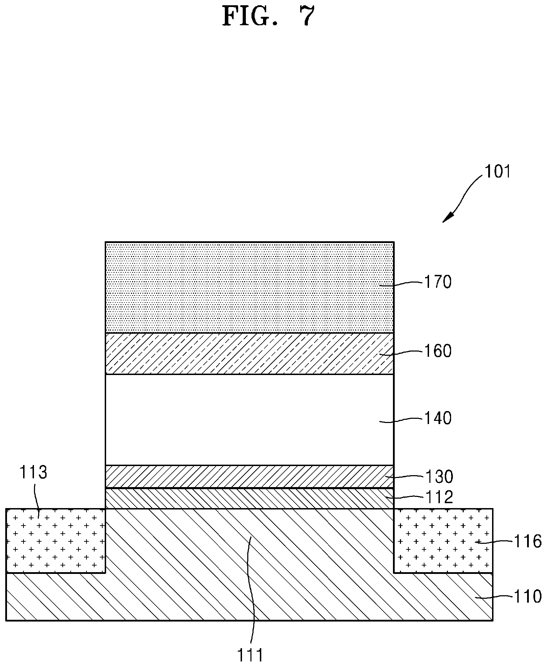

FIG. 7 is a cross-sectional view illustrating a schematic structure of a semiconductor device according to at least one embodiment.

The semiconductor device 101 of the present embodiment differs from the semiconductor device 100 of FIG. 1 in that an interface layer 112 is further included between the channel layer 111 and the second insertion layer 130. The rest of the configuration is the same or substantially similar.

The interface layer 112 may be formed by naturally oxidizing a part of a semiconductor material included in the substrate 110 and/or channel layer 111 in the process of manufacturing the semiconductor device 100. Thus, the interface layer 112 may include an oxide of a semiconductor material. For example, when the substrate 110 and/or channel layer 111 includes Si, the interface layer 112 may include $SiO_2$. When the substrate 110 and/or channel layer 111 includes Ge, the interface layer 112 may include $GeO_2$. When the substrate 110 and/or channel layer 111 includes SiGe, the interface layer 112 may include $SiGeO_4$.

In the process of manufacturing the semiconductor device 101, the second insertion layer 130 may be nitrided in order to decrease the amount of charge trap of the second insertion layer 130 and increase the dielectric constant of the second insertion layer 130. In these cases, the interface layer 112 may include an oxynitride of a semiconductor material included in the substrate 110 and/or channel layer 111. For example, the interface layer 112 may include SiON, GeON, $SiGeO_xN_y$, etc.

The thickness of the interface layer 112 may be about 1 nm to about 5 nm.

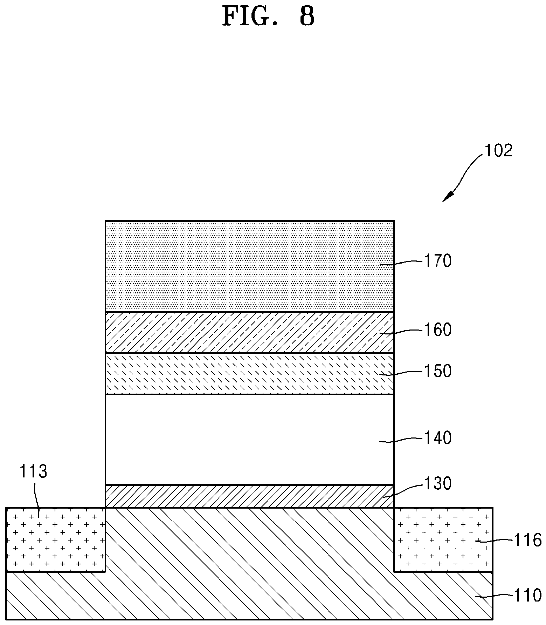

FIG. 8 is a cross-sectional view illustrating a schematic structure of a semiconductor device according to at least one embodiment.

The semiconductor device 102 of the present embodiment is different from the semiconductor device 100 of FIG. 1 in that a charge trap layer 150 is further arranged between the first insertion layer 160 and the ferroelectric layer 140. The remaining configurations may be the same and/or substantially similar.

The charge trap layer 150 may include a material having a dielectric constant less than the second paraelectric material included in the second insertion layer 130. The charge trap layer 150 may be in contact with the ferroelectric layer 140. The charge trap layer 150 may be a paraelectric material. In at least one embodiment, the charge trap layer 150 may be an amorphous-based material. The charge trap layer 150 may have large bandgap energy and a deep trap level. The charge trap layer 150 may have, for example, bandgap energy of about 4 eV or more, and may have a deep trap level lower than the conduction band. For example, the deep trap level may be lower than the conductive band by about 1.0 eV or more and/or about 1.5 eV or more. The charge trap layer 150 may include at least one of AlN, GaN, GeN, SiN, Cn, InN, Yn, ScN, and/or ZrN. Alternatively, the charge trap layer 150 may also include various nitrides, polycrystalline silicon, amorphous polysilicon, etc.

The charge trap layer 150 may have a thickness within the same as and/or similar range compared to the first insertion layer 160. A thickness of the charge trap layer 150 may be greater than a thickness of the second insertion layer 130. Alternatively, the thickness of the first insertion layer 160 and the thickness of the charge trap layer 150 may be determined so that the sum of the thickness of the charge trap layer 150 and the thickness of the first insertion layer 160 is greater than the thickness of the second insertion layer 130.

The charge trap layer 150 and the first insertion layer 160 may increase the memory window of the semiconductor device 102. Since the charge trap layer 150 is provided, an amount at which charges are trapped at an interface toward the gate electrode 170 of the ferroelectric layer 140 may be further increased, and a difference from the amount of charge trapped at an interface toward the channel layer 111 of the ferroelectric layer 140 may be further increased.

Although not shown, an interface layer 112 as described in FIG. 7 may be further formed between the channel layer 111 and the second insertion layer 130.

According to another embodiment, a semiconductor device is provided, comprising: a channel layer including a semiconductor material; a ferroelectric layer disposed on the channel layer and including a ferroelectric material; a gate electrode disposed on the ferroelectric layer; a first insertion layer between the ferroelectric layer and the gate electrode; and a second insertion layer between the channel layer and the ferroelectric layer; wherein the dielectric constant of the second insertion layer is greater than the dielectric constant of the first insertion layer.

A ratio of a dielectric constant of the second insertion layer to a dielectric constant of the first insertion layer may be greater than 1.0, greater than or equal to 1.1, greater than or equal to 1.2, greater than or equal to 1.3, greater than or equal to 1.5, greater than or equal to 1.7, or greater than or equal to 2.0, and less than or equal to 20, less than or equal to 15, or less than or equal to 10.

The first insertion layer may include at least one of silicon oxide, silicon nitride, silicon oxynitride, and boron nitride. The second insertion layer may include at least one of $Al_2O_3$, $Ta_2O_5$, and $La_2O_3$.

Each of the first insertion layer and the second insertion layer includes one or more layers. At least one of the first insertion layer and the second insertion layer may have a multilayer structure including a plurality of layers. In this case, the dielectric constant of the first insertion layer and the dielectric constant of the second insertion layer may mean the dielectric constant of the entire first insertion layer and the dielectric constant of the entire second insertion layer, respectively. That is, the dielectric constant of the first insertion layer may be determined by the dielectric constant of the dielectric materials included in the plurality of layers forming the first insertion layer, and the dielectric constant of the second insertion layer may be determined by the dielectric constant of the dielectric materials included in the plurality of layers forming the second insertion layer.

For example, the first insertion layer may have a multilayer structure in which Si, O, and N are variously combined, such as $SiO_2$, SiN, SiON, or SiO/SiN/SiO, or etc. The first insertion layer have a multilayer structure including a layer silicon oxided and a layer silicon nitrided. In this case, the dielectric constant of the first insertion layer may be equal to or greater than 4, and equal to or greater than 7.

The semiconductor device may further include an interfacial layer between the channel layer and the second insertion layer. The semiconductor device may further include a charge trap layer between the first insertion layer and the ferroelectric layer.

The semiconductor devices 100, 101, and 102 described above may be applied to various electronic devices, and for example, may be applied to individual memory cells in a memory device. The memory device may have a three-dimensional structure, a vertical structure, and/or the like, and may have, for example, a Vertical NAND (VNAND) structure.

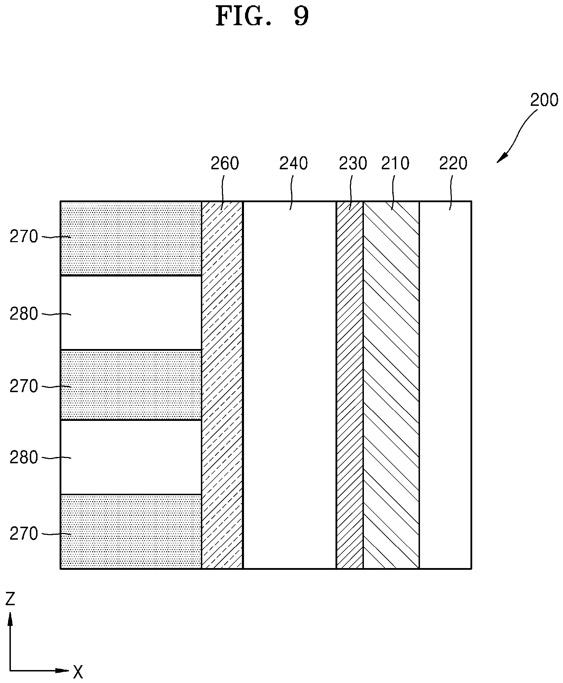

FIG. 9 is a cross-sectional view illustrating a schematic structure of a memory device according to at least one embodiment.

A memory device 200 includes a plurality of memory cells MC. The plurality of memory cells MC may be repeatedly arranged in the first direction (Z direction). Each of the memory cells MC may have a structure similar to the semiconductor device 100 described above.

The memory device 200 includes a plurality of gate electrode 270 spaced apart from each other in the first direction (Z direction). A spacer 280 including an insulating material may be arranged between adjacent gate electrodes of the gate electrodes 270. The spacer 280 may include, for example a silicon oxide (e.g., $SiO_2$, SiOC, SiON, and/or the like). However, the embodiments are not limited thereto.

One-side surface of each of the plurality of gate electrodes 270 and the plurality of spacers 280 (which are alternately arranged) may be connected to be aligned, and the first insertion layer 260 may be arranged on the connected surface, and the ferroelectric layer 240, the second insertion layer 230, and the channel layer 210 are sequentially arranged. In at least one embodiment, an insulating layer 220 may be included. However, this may be only an example, and the insulating layer 220 may be omitted. A direction in which the first insertion layer 260, the ferroelectric layer 240, the second insertion layer 230, and the channel layer 210 are sequentially arranged may be a second direction (X direction) perpendicular to the first direction (Z direction).

Each of the gate electrode 270, the first insertion layer 260, the ferroelectric layer 240, the second insertion layer 230, and the channel layer 210 may respectively include the materials presented as the materials of the gate electrode 170, the first insertion layer 160, the ferroelectric layer 140, the first insertion layer 230, and the channel layer 210 described above.

Each of the gate electrodes 270 and regions of the first insertion layer 260, the ferroelectric layer 240, the second insertion layer 230, and the channel layer 210 facing the gate electrodes 270 form individual memory cells MC.

Additionally, although not shown, an interface layer (as described in FIG. 7) may be further formed between the channel layer 210 and the second insertion layer 230.

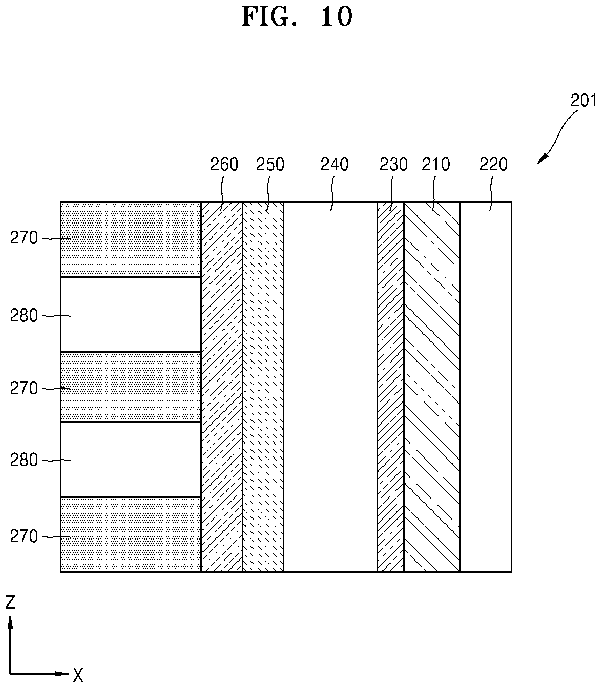

FIG. 10 is a cross-sectional view illustrating a schematic structure of a memory device according to at least one embodiment.

A memory device 201 of the present embodiment is different from the memory device 200 of FIG. 9 in that a charge trap layer 250 is further arranged between the first insertion layer 260 and the ferroelectric layer 240, and the remaining configurations are substantially the same. The charge trap layer 250 may include the material described in the charge trap layer 150 of FIG. 8.

Additionally, although not shown, an interface layer (as described in FIG. 7) may be further formed between the channel layer 210 and the second insertion layer 230.

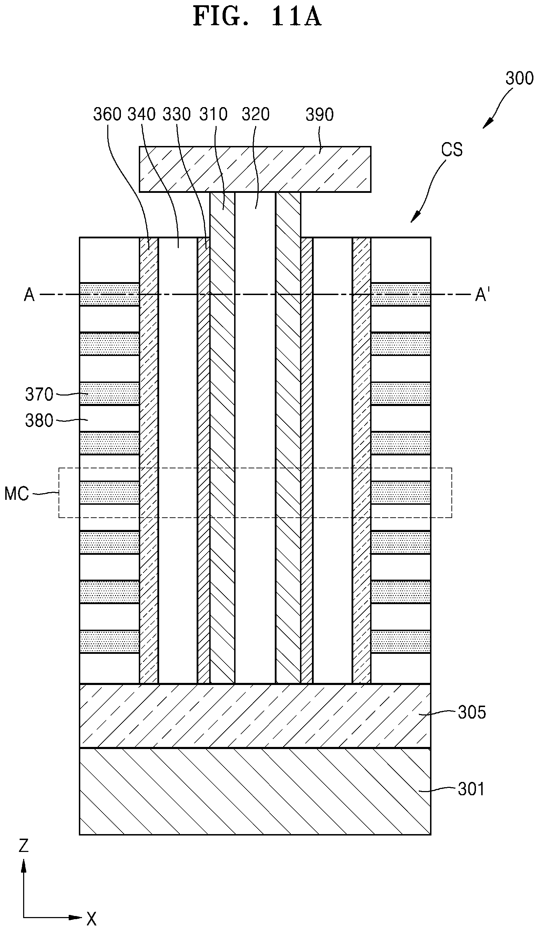

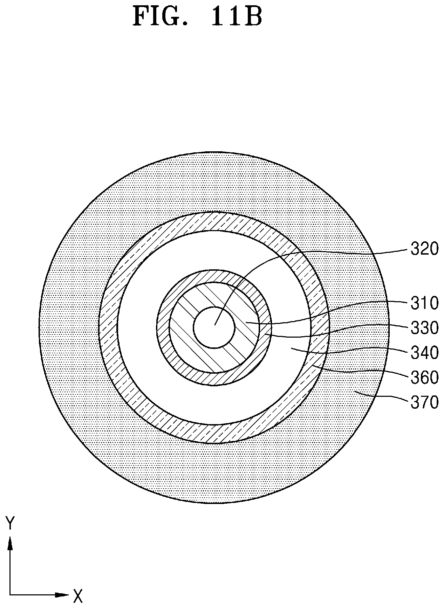

FIG. 11A is a cross-sectional view of a schematic structure of a memory device according to at least one embodiment, and FIG. 11B is a cross-sectional view taken along line AA' of FIG. 11A.

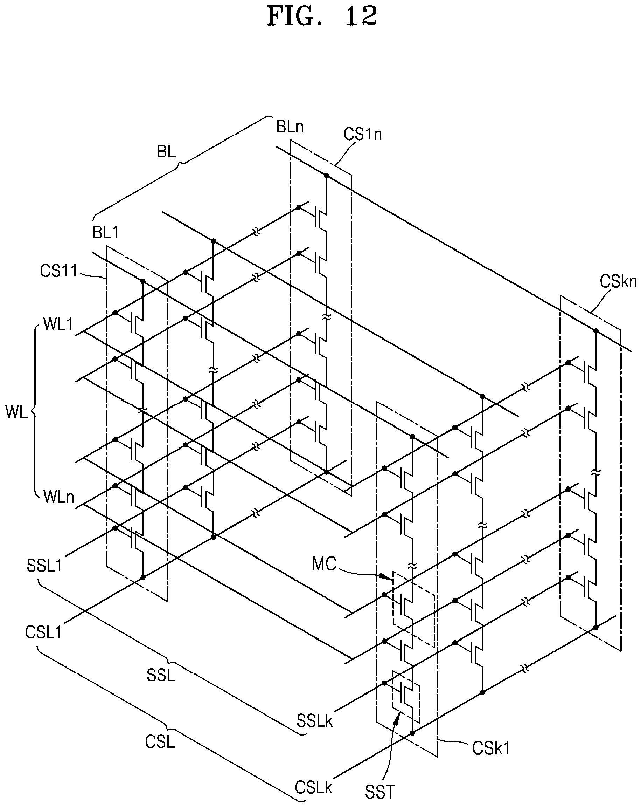

Referring to FIG. 11A, a memory device 300 may include a substrate 301 and a cell string CS formed on a substrate 301. One cell string CS is illustrated in the drawing, but this is only an example, and the memory device 300 may include a plurality of cell strings. For example, the plurality of cell strings CS may extend along the first direction (Z direction) away from the substrate 301 and may be two-dimensionally arranged in the second and third directions (X and Y direction) perpendicular to the first direction. As will be illustrated later in the circuit diagram of FIG. 12, these plurality of cell strings may be provided with k*n and arranged in a matrix form, and may be referred to as CSij where $1{\leq}i{\leq}k$ and $1{\leq}j{\leq}n$ according to the positions of each row and column.

The substrate 301 may be a semiconductor substrate. The substrate 301 may include a silicon material doped with first type impurities. For example, the substrate 301 may include a silicon material doped with p-type impurities. For example, the substrate 301 may be a p-type well (e.g., a pocket p-well). However, the embodiments are not limited thereto, and the substrate 301 may include various semiconductor materials and/or dopant types.

A common source region 305 is provided on the substrate 301. The common source region 305 may be of a type different from a semiconductor material included in the substrate 301, and may be, for example, an n-type. The common source region 305 may be connected to, for example, the common source line CSL shown in the circuit diagram of FIG. 12.

As illustrated in the cross-sectional view of FIG. 11B, the cell string CS may have a circular cross-section. For example, the cell string CS may have a cylindrical shape with a central axis parallel to the Z direction. However, this is merely an example, and the cell string CS may be modified in the form of an elliptical pillar or a polygonal pillar.

The plurality of gate electrodes 370 are arranged to be spaced apart from each other in the axial direction of the cell string CS, for example, in the Z direction, and a spacer 380 including an insulating material may be arranged between every two adjacent gate electrodes of the plurality of gate electrodes 370.

The gate electrodes 370 and the spacers 380 may have a cylindrical shell shape of which the inner surfaces are connected to each other, and a first insertion layer 360 may be conformally formed on the inner surfaces. In addition, the ferroelectric layer 340 may be conformally formed on the first insertion layer 360, and then the second insertion layer 330 and the channel layer 310 may be conformally formed.

The cell string CS may be filled with a cylindrical insulating layer 320 in a central portion thereof. However, this may be only an example, and the insulating layer 320 may be omitted or formed in a cylinder shell form.

The materials of the channel layer 310, the second insertion layer 330, the ferroelectric layer 340, the first insertion layer 360, and the gate electrode 370 may include materials illustrated in the channel layer 111, the second insertion layer 130, the ferroelectric layer 140, the first insertion layer 160, and the gate electrode 170 described with reference to FIG. 1.

One end of the channel layer 310 (e.g., the region of the channel layer 310 positioned at the lowermost end of the cell string CS) may be in contact with the common source region 305.

A drain region 390 may be provided on the cell string CS. The drain 390 may include, for example, a silicon material doped in an n-type. The other end of the channel layer 310 (e.g., a region of the channel layer 310 located at the uppermost end of the cell string CS) may be in contact with the drain 390. The drain 390 may be connected to the bit line through contact plugs.

The gate electrodes 370 and regions of the first insertion layer 360, the ferroelectric layer 340, the second insertion layer 330, and the channel layer 310 facing the gate electrodes 370 form memory cells MC.

The memory cells MC are continuously arranged in the vertical direction (Z direction) to constitute the cell string CS. In addition, the common source region 305 and drain 390, respectively connected to both ends of the cell string CS, may be connected to the common source line CSL and the bit line BL, respectively, shown in the circuit diagram of FIG. 12. The gate electrodes 370 are connected to the word lines WL. By applying a voltage to the word line WL, the common source line CSL, and the bit line BL, a program, read, and erase process may be performed on the plurality of memory cells MC.

As described above, the ferroelectric layer 340 is a material in which the polarization value remains semi-permanently in the material even if the voltage is brought back to 0 V after applying a certain voltage to the ferroelectric layer 340, and the polarity (direction) of the residual polarization may depend on the polarity (direction) of the voltage applied from the outside. The region of the ferroelectric layer 340 corresponding to each memory cell MC may have residual polarization corresponding to an electric field formed in the ferroelectric layer 340 by a voltage applied to the gate electrode 370. Due to the polarization direction of the ferroelectric layer 340, a conductance difference may occur in the region of the channel layer 310 corresponding to the memory cell MC, and through this, information may be written or confirmed.

In addition, the memory device 300 according to the embodiment includes the first insertion layer 360 and the second insertion layer 330 made of a paraelectric material that satisfies a predetermined dielectric constant ratio so that the memory window may be increased, and thus, the reliability of the memory operation may be improved.

FIG. 12 is a diagram illustrating an equivalent circuit of a memory device according to at least one embodiment. Referring to FIG. 12, a memory device may include a plurality of memory cell strings CS11 to CSkn. The plurality of memory cell strings CS11 to CSkn may be two-dimensionally arranged in a row direction and a column direction to form rows and columns. Each cell string CSij where $1 \leq i \leq k$ and $1 \leq j \leq n$ may be coupled to a bit line BL, a string selection line SSL, a word line WL, and a common source line CSL.

The cell strings CSij includes memory cells MC and string selection transistors SST. The memory cells MC and the string selection transistor SST of each cell string CSij may be stacked in a height direction.

The rows of the plurality of cell strings CSij are connected to different string selection lines SSL1 to SSLk, respectively. For example, the string selection transistors SST of the cell strings CS11 to CS1n are commonly connected to the string selection line SSL1. The string selection transistors SSTs of the cell strings CSk1 to CSkn are commonly connected to the string selection line SSLk.

Columns of the plurality of cell strings CSij are connected to different bit lines BL1 to BLn, respectively. For example, memory cells MC and string selection transistors SST of the cell strings CS11 to CSk1 may be commonly connected to the bit line BL1, and memory cells MC and string selection transistors SST of the cell strings CS1n to CSkn may be commonly connected to the bit lines BL1 to BLn.

The rows of the plurality of cell strings CSij may be connected to different common source lines CSL1 to CSLk, respectively. For example, string selection transistors SST of the cell strings CS11 to CS1n may be commonly connected to a common source line CSL1, and string selection transistors SST of the cell strings CSk1 to CSkn may be commonly connected to a common source line CSLk.

The string selection transistors SST and/or the memory cells MC located at the same height from the substrate 301 of FIG. 11A may be commonly connected to one of the word lines WL1 to WLm, and the memory cells MC located at different heights may be connected to different word lines WL1 to WLm, respectively.

In this structure, write and read operations may be performed in units of the rows of the memory cell strings CS11 to CSkn. For example, the memory cell strings CS11 to CSkn may be selected as a unit of one row by the common source lines CSL, and the memory cell strings CS11 to CSkn may be selected as a unit of one row by the string selection lines SSL. In addition, in the selected row of the memory cell strings CS11 to CSkn, write and/or read operations may be performed in units of pages. For example, the page may be one row of memory cells MC coupled to one word line WL. In the selected row of the memory cell strings CS11 to CSkn, the memory cells MC may be selected in units of pages by word lines WL.

The illustrated circuit structure is only an example. For example, the number of rows of the cell strings CSij where $1 \leq i \leq k$ and $1 \leq j \leq n$ may increase or decrease. As the number of rows of the cell strings CS is changed, the number of string selection lines connected to the rows of the cell strings CS and the number of cell strings CS connected to one bit line BL may also be changed. As the number of rows of the cell strings CS is changed, the number of common source lines connected to rows of the cell strings CS may also be changed.

The number of columns of the cell strings CS may also increase or decrease. As the number of columns of the cell strings CSij is changed, the number of bit lines BL connected to the columns of the cell strings CSij and the number of cell strings CSij connected to one string selection line may also be changed.

The height of the cell string CSij may also increase or decrease compared to the illustration. For example, the number of cells MC stacked in each of the cell strings CSij may greater than or less than what is illustrated. As the number of memory cells MC stacked in each of the cell strings CSij is changed, the number of word lines WL may also be changed. For example, the number of the string selection transistors provided in each of the cell strings CSij may increase. As the number of string selection transistors provided to each of the cell strings CSij is changed, the number of string selection lines or common source lines may also be changed. When the number of string selection transistors increases, the string selection transistors may be stacked in the same form as the memory cells MCs.

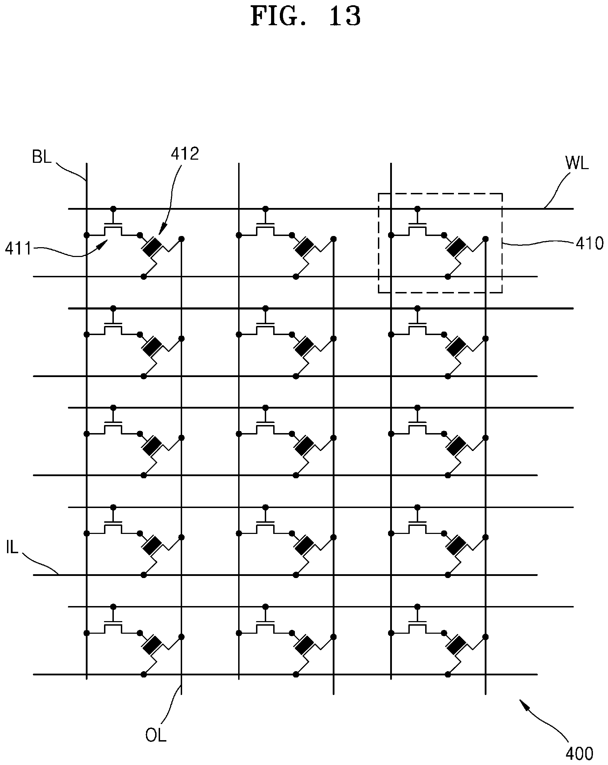

FIG. 13 is a schematic circuit diagram of a neural network device according to at least one embodiment. Referring to FIG. 13, a neural network device 400 according to at least one embodiment may include an array of a plurality of synapse devices 410 provided in two dimensions. Each of the plurality of synapse elements 410 may include an access transistor 411 and a ferroelectric field effect transistor 412. The ferroelectric field effect transistor 412 may be any one of the semiconductor devices 100, 101, and 102 described with reference to FIGS. 1 to 8, or a semiconductor device according to a combination thereof or a modification thereof. The access transistor 411 may serve as a selection element for turning on/off the synapse element 410.

The neural network device 400 may also include a plurality of word lines WL, a plurality of bit lines BL, a plurality of input lines IL, and a plurality of output lines OL. The gate of the access transistor 411 may be electrically connected to any one of the plurality of word lines WL, the source thereof may be electrically connected to any one of the plurality of bit lines BL, and the drain thereof may be connected to the gate of the ferroelectric field effect transistor 412. Further, the source of the ferroelectric field effect transistor 412 may be electrically connected to an input line of any one of the plurality of input lines IL, and a drain thereof may be electrically connected to an output line of any one of the plurality of output lines OL.

During the learning operation of the neural network device 400, the access transistor 411 is individually turned on through individual word lines WL, and a program pulse may be applied to the gate of the ferroelectric field effect transistor 412 through the bit lines BL. A signal of the training data may be applied through the input line IL. Through this process, weights may be stored in each ferroelectric field effect transistor 412.

During the inference operation of the neural network device 400, all access transistors 411 may be turned on through the entire word lines WL, and a read voltage Vread may be applied through the bit lines BL. Then, the current from each of the synapse elements 410 connected in parallel to the output line OL is added to and flows in each output line OL. An output circuit is connected to the plurality of output lines OL to convert a current flowing through each output line OL into a digital signal.

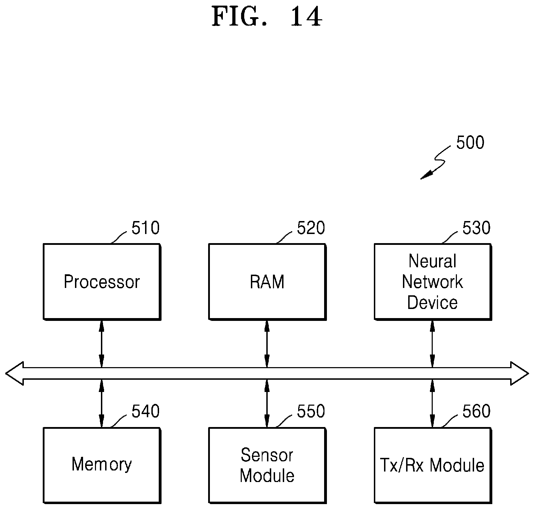

FIG. 14 is a block diagram schematically illustrating an example configuration of an electronic device including a neural network device. Referring to FIG. 14, the electronic device 500 may analyze input data in real time based on a neural network to extract valid information, determine a situation based on the extracted information, or control configurations of a device equipped with the electronic device 500. For example, the electronic device 500 may be applied to a robot device such as a drone, an advanced driver assistance system (ADAS), and/or the like, a smart TV, a smartphone, a medical device, a mobile device, an image display device, a measurement device, and an IoT device, and the like, and may be mounted on at least one of various types of devices.

The electronic device 500 may include a processor 510, a random access memory (RAM) 520, a neural network device 530, a memory 540, a sensor module 550, and a communication (transmission (Tx)/reception (Rx)) module 560. The electronic device 500 may further include an input/output module, a security module, a power control device, and the like. Some of the hardware components of the electronic device 500 may be mounted on at least one semiconductor chip.

The processor 510 controls the overall operation of the electronic device 500. The processor 510 may include a single processor core or a plurality of processor cores (i.e., MultiCore). The processor 510 may process or execute programs and/or data stored in the memory 540. In some embodiments, the processor 510 may control the function of the neural network device 530 by executing programs stored in the memory 540. The processor 510 may be implemented as a central processing unit (CPU), a graphics processing unit (GPU), an application processor (AP), or the like.

The RAM 520 may temporarily store programs, data, or instructions. For example, programs and/or data stored in the memory 540 may be temporarily stored in the RAM 520 according to the control or boot code of the processor 510. The RAM 520 may be implemented as a memory such as dynamic RAM (DRAM), static RAM (SRAM), and/or the like.

The neural network device 530 may perform an operation of the neural network based on the received input data and generate an information signal based on the execution result. The neural network may include, but is not limited to, CNN, RNN, FNN, long short-term memory (LSTM), stacked neural network (SNN), state-space dynamic neural network (SSDNN), deep belief networks (DBN), restricted Boltzmann machine (RBM), and the like. The neural network device 530 may be a hardware accelerator itself dedicated to a neural network or a device including the same. The neural network device 530 may perform a read or write operation as well as an operation of the neural network. The neural network device 530 may include neural network device 400 described with reference to FIG. 13 and/or one of the semiconductor devices 100, 101, and 102 described with reference to FIGS. 1 to 8.

The information signal may include one of various types of recognition signals such as a voice recognition signal, an object recognition signal, an image recognition signal, a biometric information recognition signal, and the like. For example, the neural network device 530 may receive frame data included in the video stream as input data and generate, from frame data, a recognition signal for an object included in an image represented by the frame data. However, the neural network device is not limited thereto, and the neural network device 530 may receive various types of input data and generate a recognition signal according to the input data according to the type or function of the device on which the electronic device 500 is mounted.

The neural network device 530 may perform, for example, machine learning model such as linear regression, logistic regression, statistical clustering, Bayesian classification, decision trees, principal component analysis, and/or expert system, and/or machine learning model of ensemble techniques, etc., such as random forest. The machine learning model may be used to provide various services such as, for example, image classification service, user authentication service based on biometric information and/or biometric data, advanced driver assistance system (ADAS), voice assistant service, automatic speech recognition (ASR) service, and/or the like.

The memory 540 is a storage place for storing data and may store an operating system (OS), various programs, and various pieces of data. In at least one embodiment, the memory 540 may store intermediate results generated during the operation of the neural network device 530.

The memory 540 may be a DRAM, but is not limited thereto. The memory 540 may include at least one of a volatile memory and/or a nonvolatile memory. The nonvolatile memory includes read-only memory (ROM), programmable ROM (PROM), electrically programmable ROM (EPROM), electrically erasable and programmable ROM (EEPROM), flash memory, phase-change ROM (PROM), magnetic ROM (MROM), resistive ROM (RROM), ferroelectric ROM (FROM), and the like. The volatile memory includes dynamic RAM (DRAM), static RAM (SRAM), synchronous DRAM (SDRAM), phase-change RAM (PRAM), magnetic RAM (MRAM), resistive RAM (RRAM), and ferroelectric RAM (FeRAM). In at least one embodiment, the memory 540 may include at least one of a hard disk drive (HDD), a solid state drive (SSD), a compact flash (CF), a secure digital (SD), a micro secure digital (Micro-SD), a mini secure digital (Mini-SD), a memory stick, and/or the like. In at least one embodiment, the memory 540 may include one of the semiconductor devices 100, 101, 102, 300 described with reference to FIGS. 1 to 8 and 11A to 11B.

The sensor module 550 may collect information around a device on which the electronic device 500 is mounted. The sensor module 550 may sense and/or receive a signal (e.g., an image signal, a voice signal, a magnetic signal, a bio signal, a touch signal, etc.) from the outside of the electronic device 500 and convert the sensed and/or received signal into data. To this end, the sensor module 550 may include at least one of various types of sensing devices such as a sensing device, for example, a microphone, an imaging device, an image sensor, a light detection and ranging (LIDAR) sensor, an ultrasonic sensor, an infrared sensor, a biosensor, and a touch sensor.

The sensor module 550 may provide the converted data to the neural network device 530 as input data. For example, the sensor module 550 may include an image sensor, generate a video stream by photographing an external environment of the electronic device 500, and sequentially provide the continuous data frame of the video stream to the neural network device 530 as input data. However, embodiments are not limited thereto, and the sensor module 550 may provide various types of data to the neural network device 530.

The communication module 560 may include various wired or wireless interfaces capable of communicating with an external device. For example, the communication module 560 may include a wired local area network (LAN), a wireless local area network (WLAN) such as a wireless fidelity (Wi-Fi), a wireless personal area network (WPAN) such as Bluetooth, a wireless universal serial bus (USB), Zigbee, near field communication (NFC), radio-frequency identification (RFID), power line communication (PLC), and a communication interface capable of connecting to a mobile cellular network, such as 3rd generation (3G), 4th generation (4G), long term evolution (LTE), and the like.

The semiconductor device described above may operate as a field effect transistor having an increased memory window.

The semiconductor device described above may have improved operation reliability and may be used as a memory cell of a memory device.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

**Claims**

**1.** A semiconductor device comprising:

a channel layer including a semiconductor material;
a ferroelectric layer on the channel layer and including a ferroelectric material;
a gate electrode on the ferroelectric layer;
a first insertion layer between the ferroelectric layer and the gate electrode, the first insertion layer including a first paraelectric material; and
a second insertion layer between the channel layer and the ferroelectric layer, the second insertion layer including a second paraelectric material having a dielectric constant higher than a dielectric constant of the first paraelectric material.

2. The semiconductor device of claim 1, wherein the second paraelectric material is a high-k material.

3. The semiconductor device of any preceding claim, wherein the first paraelectric material has a band gap energy greater than a band gap energy of the ferroelectric material included in the ferroelectric layer.

4. The semiconductor device of any preceding claim, wherein the second paraelectric material includes at least one of SiON, GeON, $SiGeO_xN_y$, $Al_2O_3$, $Y_2O_3$, $SrTa_2O_7$, $HfO_2$, $ZrO_2$, $Ta_2O_5$, SrTiO3, $La_2O_3$, $SrHfO_3$, $BaZrO_3$, $BaHfO_3$, $Ta_2Ti_2O_x$, $TiO_2$, or $BaHf_{0.5}Ti_{0.5}O_3$ and optionally wherein the second paraelectric material includes at least one of $Al_2O_3$, $Ta_2O_5$, or $La_2O_3$.

5. The semiconductor device of any preceding claim, wherein the first paraelectric material includes at least one or more of silicon oxide, silicon nitride, silicon oxynitride, or boron nitride.

6. The semiconductor device of any preceding claim, wherein the dielectric constant of the second paraelectric material is equal to or greater than 8 and equal to or less than 60.

7. The semiconductor device of any preceding claim, wherein a thickness of the second insertion layer is less than a thickness of the first insertion layer, and optionally wherein the thickness of the second insertion layer is 70 % or less of the thickness of the first insertion layer.

8. The semiconductor device of any preceding claim, wherein a ratio of the dielectric constant of the second paraelectric material to the dielectric constant of the first paraelectric material is greater than or equal to 1.2.

9. The semiconductor device of any preceding claim, further comprising:
an interface layer between the channel layer and the second insertion layer, the interface layer including an oxide.

10. The semiconductor device of any preceding claim, further comprising:
a charge trap layer between the ferroelectric layer and the first insertion layer, the charge trap layer contacting the ferroelectric layer, and optionally wherein a trap level of the charge trap layer is lower than a conduction band of the charge trap layer by 1 eV or more.

11. The semiconductor device of claim 10, wherein the charge trap layer includes at least one AlN, GaN, GeN, SiN, CN, InN, YN, ScN, or ZrN.

12. The semiconductor device of claim 10, wherein a dielectric constant of a paraelectric material included in the charge trap layer is less than the dielectric constant of the second paraelectric material.

13. The semiconductor device of any preceding claim, wherein the first insertion layer has a multilayer structure including a layer silicon oxided and a layer silicon nitrided.

14. The semiconductor device of any preceding claim, wherein the first insertion layer includes one or more layer and the second insertion layer includes one or more layer, wherein a ratio of the dielectric constant exhibited by the entire second insertion layer to the dielectric constant exhibited by the entire first insertion layer is greater than or equal to 1.2.

15. An electronic device comprising:

a semiconductor substrate; and
a plurality of semiconductor devices according to any preceding claim on the semiconductor substrate and stacked in a first direction,
wherein the channel layer, the second insertion layer, the ferroelectric layer, the first insertion layer, and the gate electrode are sequentially disposed in a second direction perpendicular to the first direction.

FIG. 1

FIG. 2

# FIG. 3

# FIG. 4

# FIG. 5

FIG. 6A

FIG. 6B

# FIG. 7

101

170

160

140

113

130

112

116

110

111

# FIG. 8

# FIG. 9

# FIG. 10

# FIG. 11A

# FIG. 11B

# FIG. 12

# FIG. 13

# FIG. 14

500

| 510 | 520 | 530 |
| --- | --- | --- |
| Processor | RAM | Neural Network Device |

| 540 | 550 | 560 |
| --- | --- | --- |
| Memory | Sensor Module | Tx/Rx Module |

Europäisches
Patentamt

European
Patent Office

Office européen
des brevets

# EUROPEAN SEARCH REPORT

**Application Number**

EP 24 20 6188

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/020773 A1 (LEE KUN YOUNG [KR] ET AL) 20 January 2022 (2022-01-20) | 1-6,8, 12,15 | INV. H10D30/69 |
| Y | * paragraphs [0030] - [0060]; figures 2A, 2B * | 7,9-11, 13,14 | ADD. H10B51/30 |
| Y | US 2023/085754 A1 (INO TSUNEHIRO [JP] ET AL) 23 March 2023 (2023-03-23) * paragraphs [0043] - [0050]; figure 1 * | 7 | |
| Y | US 2023/012093 A1 (KAKUSHIMA KUNIYUKI [JP] ET AL) 12 January 2023 (2023-01-12) * paragraphs [0165] - [0169]; figure 14B * | 9 | |
| Y | US 2019/304987 A1 (DONG YINGDA [US] ET AL) 3 October 2019 (2019-10-03) * paragraphs [0021] - [0034]; figure 1C * | 10,11, 13,14 | |

**TECHNICAL FIELDS SEARCHED (IPC)**

H10B
H10D

The present search report has been drawn up for all claims

| Place of search | Date of completion of the search | Examiner |
|---|---|---|
| Munich | 6 February 2025 | Alessio Verni, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 6188

This annex lists the patent family members relating to the patent documents cited in the above-mentioned European search report.
The members are as contained in the European Patent Office EDP file on
The European Patent Office is in no way liable for these particulars which are merely given for the purpose of information.

06-02-2025

| Patent document cited in search report | Publication date | Patent family member(s) | Publication date |
|---|---|---|---|
| US 2022020773 A1 | 20-01-2022 | CN 113948530 A | 18-01-2022 |
| | | KR 20220009296 A | 24-01-2022 |
| | | US 2022020773 A1 | 20-01-2022 |
| | | US 2022278131 A1 | 01-09-2022 |
| US 2023085754 A1 | 23-03-2023 | JP 2023044116 A | 30-03-2023 |
| | | US 2023085754 A1 | 23-03-2023 |
| US 2023012093 A1 | 12-01-2023 | JP WO2021112247 A1 | 10-06-2021 |
| | | US 2023012093 A1 | 12-01-2023 |
| | | WO 2021112247 A1 | 10-06-2021 |
| US 2019304987 A1 | 03-10-2019 | NONE | |

EPO FORM P0459

For more details about this annex : see Official Journal of the European Patent Office, No. 12/82